# EUROPEAN PATENT APPLICATION

(11) **EP 3 029 496 A1**
(43) Date of publication of application: **08.06.2016**
(21) Application number: 15170977.1
(22) Date of filing: 08.06.2015
(51) Int. Cl.: G02B 5/30, G02F 1/1335

(54) **WIRE GRID POLARIZER AND METHOD OF FABRICATING THE SAME**

(30) Priority: 05.12.2014 KR 20140173928
(71) Applicant: Samsung Display Co., Ltd., Gyeonggi-do (KR)
(72) Inventor: Kim, Jin Lak, No. 315-704 Gyeonggi-do (KR); Kang, Tae Wook, No. 311-403 Gyeonggi-do (KR); Kim, Tae Gyun, No. 167-901 Seoul (KR)
(74) Representative: Dr. Weitzel & Partner

(57) **Abstract**

A wire grid polarizer and a method of fabricating a wire grid polarizer are provided. The wire grid polarizer comprises a substrate (110) configured to have a plurality ot recessed patterns (110a) disposed on a first surface thereof, a plurality of conductive wire patterns (121) configured to be disposed in the recessed patterns, respectively, of the substrate, and an oxide layer (123) configured to be disposed on the substrate and the conductive wire patterns.

## Description

This application claims priority to Korean Patent Application No. 10-2014-0173928 filed on December 05, 2014 in the Korean Intellectual Property Office, the disclosure of which is incorporated herein by reference in its entirety.

### BACKGROUND

### 1. Field

This application relates to a wire grid polarizer and a method of fabricating the same.

### 2. Description of the Related Art

A parallel conduction wire array in which conductor wires are arranged in parallel to one another to polarize certain light from electromagnetic waves is generally referred to as a wire grid polarizer.

In response to non-polarized light being incident, a wire grid polarizer with a smaller period than the wavelength of the incident light reflects polarized light parallel to a direction of the wires thereof, and transmits therethrough polarized light perpendicular to the direction of the wires thereof. A wire grid polarizer is more beneficial than an absorptive polarizer in that it allows reflected polarized light to be reused.

### SUMMARY

Exemplary embodiments provide a wire grid polarizer with excellent processability, a display device having the wire grid polarizer, and a method of fabricating the wire grid polarizer.

However, exemplary embodiments are not restricted to those set forth herein. The above and other exemplary embodiments will become more apparent to one of ordinary skill in the art to which the application pertains by referencing the detailed description given below.

According to an exemplary embodiment, there is provided a wire grid polarizer, comprising a substrate configured to have a plurality of recessed patterns disposed on a first surface thereof, a plurality of conductive wire patterns configured to be disposed in the recessed patterns, respectively, of the substrate, and an oxide layer configured to be disposed on the substrate and the conductive wire patterns.

According to another exemplary embodiment, there is provided a wire grid polarizer, comprising a substrate configured to have a plurality of first recessed patterns disposed on a first surface thereof and a second recessed pattern also disposed on the first surface thereof with a width larger than a width of the first recessed patterns, a plurality of conductive wire patterns configured to be disposed in the first recessed patterns, respectively, of the substrate, a reflective layer configured to be disposed in the second recessed pattern of the substrate, and an oxide layer configured to be disposed on the substrate, the conductive wire patterns and the reflective layer.

According to still another exemplary embodiment, there is provided a method of fabricating a wire grid polarizer, the method comprising forming a plurality of recessed patterns on a first surface of a substrate, forming a conductive material layer on the first surface of the substrate to form a plurality of conductive wire patterns in the recessed patterns, respectively, and oxidizing part of the conductive material layer on the substrate.

According to still another exemplary embodiment, there is provided a method of fabricating a wire grid polarizer, the method comprising forming a plurality of first recessed patterns and a second recessed pattern with a width larger than a width of the first recessed patterns on a first surface of a substrate, forming a conductive material layer on the first surface of the substrate to form a plurality of conductive wire patterns in the first recessed patterns, respectively, and a reflective layer in the second recessed pattern, and oxidizing part of the conductive material layer on the substrate.

According to the exemplary embodiments, it is possible to provide a wire grid polarizer with excellent processability.

Other features and exemplary embodiments will be apparent from the following detailed description, the drawings, and the claims.

### BRIEF DESCRIPTION OF THE DRAWINGS

FIG. 1 is a vertical cross-sectional view of a wire grid polarizer according to an exemplary embodiment.
FIG. 2 is a vertical cross-sectional view of a wire grid polarizer according to another exemplary embodiment.
FIG. 3 is a vertical cross-sectional view of a wire grid polarizer according to another exemplary embodiment.
FIG. 4 is a vertical cross-sectional view of a wire grid polarizer according to another exemplary embodiment.
FIG. 5 is a vertical cross-sectional view of a wire grid polarizer according to another exemplary embodiment.
FIG. 6 is a vertical cross-sectional view of a wire grid polarizer according to another exemplary embodiment.
FIGS. 7, 8, 9, 10, 11, 12 and 13 are cross-sectional views illustrating a method of fabricating a wire grid polarizer, according to an exemplary embodiment.
FIGS. 14, 15, 16, 17, and 18 are cross-sectional views illustrating a method of fabricating a wire grid polarizer, according to another exemplary embodiment.
FIGS. 19, 20, 21, 22, 23, 24, and 25 are cross-sectional views illustrating a method of fabricating a wire grid polarizer, according to another exemplary embodiment.
FIGS. 26, 27, 28, 29, and 30 are cross-sectional views illustrating a method of fabricating a wire grid polarizer, according to another exemplary embodiment.

### DETAILED DESCRIPTION OF THE EMBODIMENTS

The aspects and features of the inventive concept and methods for achieving the aspects and features will be apparent by referring to the embodiments to be described in detail with reference to the accompanying drawings. However, the inventive concept is not limited to the embodiments disclosed hereinafter, but can be implemented in diverse forms. The matters defined in the description, such as the detailed construction and elements, are nothing but specific details provided to assist those of ordinary skill in the art in a comprehensive understanding of the inventive concept, and the inventive concept is only defined within the scope of the appended claims. In the entire description, the same reference numerals are used for the same elements across various figures. In the drawings, sizes and relative sizes of layers and areas may be exaggerated for clarity in explanation.

The term "on" that is used to designate that an element is on another element located on a different layer or a layer includes both a case where an element is located directly on another element or a layer and a case where an element is located on another element via another layer or still another element.

Although the terms "first, second, and so forth" are used to describe diverse constituent elements, such constituent elements are not limited by the terms. The terms are used only to discriminate a constituent element from another constituent element. Accordingly, in the following description, a first constituent element may be a second constituent element.

Exemplary embodiments will hereinafter be described with reference to the accompanying drawings.

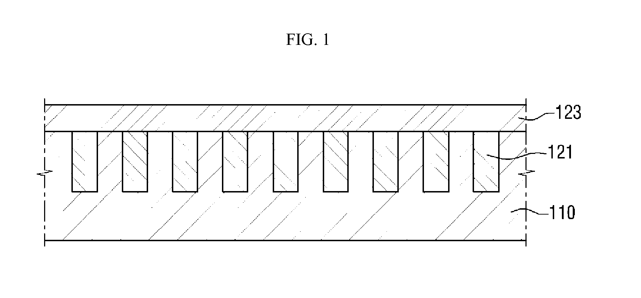

FIG. 1 is a vertical cross-sectional view of a wire grid polarizer according to an exemplary embodiment.

Referring to FIG. 1, the wire grid polarizer according to an exemplary embodiment may include a substrate 110, which has a plurality of recessed patterns formed thereon, a plurality of conductive wire patterns 121, which are disposed in the recessed patterns, respectively, of the substrate 110, and an oxide layer 123, which is disposed on the substrate 110 and the conductive wire patterns 121.

The material of the substrate 110 may be appropriately selected in consideration of the purpose of use of the substrate 110 and the type of processing that the substrate 110 is to be subjected, as long as it allows the substrate 110 to transmit visible light therethrough. In an exemplary embodiment, the substrate 110 may be formed of various polymers such as glass, quartz, acrylic, triacetyl cellulose (TAC), a cyclic olefin copolymer (COP), a cyclic olefin polymer (COC), polycarbonate (PC), polyethylenenaphthalate (PET), or polyethersulfone (PES), but the embodiments are not limited thereto. The substrate 110 may be formed of an optical film material with a certain degree of flexibility.

To achieve desired polarization properties, a material with a low refractive index may be used to form the substrate 110 in consideration that the substrate 110 is disposed among the conductive wire patterns 121. In an exemplary embodiment, the substrate 110 may have a refractive index of 1.0 to 1.7, but the embodiments are not limited thereto.

The conductive wire patterns 121 may be arranged side-by-side on the substrate 110 with a regular period. The period is the center to center spacing of the conductive wire patterns 121. The shorter the period of the conductive wire patterns 121, the higher the polarized light extinction ratio of the conductive wire patterns 121 with respect to the wavelength of incident light, but the more difficult it becomes to fabricate the conductive wire patterns 121. Visible light generally falls within the range of wavelengths of about 380 nm to about 780 nm. In order for the wire grid polarizer according to an exemplary embodiment to have a high extinction ratio with respect to light of the three primary colors (i.e., red (R), green (G) and blue (B)) of light, the conductive wire patterns 121 may need to be formed to have a period of at least about 200 nm or less to adequately perform polarization. The conductive wire patterns 121 may be formed to have a period of 120 nm or less to offer at least as high a polarization performance as a related-art polarizer, but the embodiments are not limited thereto.

The conductive wire patterns 121 may be formed of any conductive material. In an exemplary embodiment, the conductive wire patterns 121 may be formed of a metal material, and particularly, a metal selected from the group consisting of aluminum (Al), chromium (Cr), gold (Au), silver (Ag), copper (Cu), nickel (Ni), iron (Fe), tungsten (W), cobalt (Co) and molybdenum (Mo), or an alloy thereof, but the embodiments are not limited thereto.

The width of the conductive wire patterns 121 may be smaller than the period of the conductive wire patterns 121, and may be set to a range in which the conductive wire patterns 121 may provide favorable polarization performance, for example, a range of about 10 nm to about 200 nm, but the embodiments are not limited thereto. The thickness of the conductive wire patterns 121 may be set to a range of about 10 nm to about 500 nm, but the embodiments are not limited thereto. As used herein, width is in the horizontal direction and thickness is in the vertical direction in the view of the figures.

The oxide layer 123 may be formed on the substrate 110 and the conductive wire patterns 121. In an exemplary embodiment, the oxide layer 123 may be formed of an oxide of the material of the conductive wire patterns 121.

The oxide layer 123 may be formed to such a thickness that the conductive wire patterns 121 can be effectively insulated from wiring or thin-film transistor (TFT) devices to be formed during subsequent processes. In an exemplary embodiment, the oxide layer 123 may be formed to a thickness of 100 nm to 1000 nm, in which case, the oxide layer 123 not only can effectively insulate the conductive wire patterns 121, but also can contribute to the processability and the thinness of a display device, but the embodiments are not limited thereto. In another exemplary embodiment, the oxide layer 123 may be formed to a thickness of 200 nm to 300 nm.

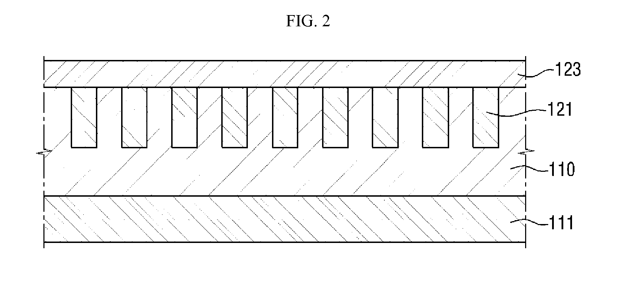

FIG. 2 is a vertical cross-sectional view of a wire grid polarizer according to another exemplary embodiment.

Referring to FIG. 2, the wire grid polarizer according to another exemplary embodiment includes a supporting substrate 111, a substrate 110, which is formed on the supporting substrate 111 and has a plurality of recessed patterns formed thereon, a plurality of conductive wire patterns 121, which are disposed in the recessed patterns, respectively, of the substrate 110, and an oxide layer 123, which is disposed on the substrate 110 and the conductive wire patterns 121.

The supporting substrate 111 may be formed on one surface of the substrate 110 to improve the supporting force or processability of the substrate 110. The recessed patterns of the substrate 110 are formed on the upper, e.g., first, surface of the substrate 110 and the supporting substrate 111 is provided on the lower, e.g., second, surface of the substrate 110 opposite the upper surface of the substrate 110.

The material of the supporting substrate 111 may be appropriately selected in consideration of the purpose of use of the substrate 110 and the type of processing that the substrate 110 is to be subjected, as long as it allows the supporting substrate 111 to transmit visible light therethrough. In an exemplary embodiment, the supporting substrate 111 may be formed of various polymers such as glass, quartz, acrylic, TAC, a COP, a COC, PC, PET, or PES, but the embodiments are not limited thereto.

The rest of the wire grid polarizer of FIG. 2 is almost the same as that of the wire grid polarizer of FIG. 1, and thus, a detailed description thereof will be omitted.

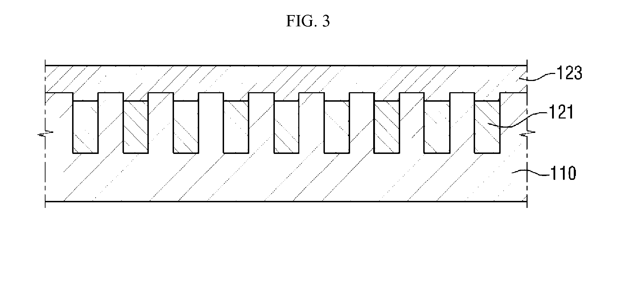

FIG. 3 is a vertical cross-sectional view of a wire grid polarizer according to another exemplary embodiment.

Referring to FIG. 3, the wire grid polarizer according to another exemplary embodiment includes a substrate 110, which has a plurality of recessed patterns formed thereon, a plurality of conductive wire patterns 121, which are disposed in the recessed patterns, respectively, of the substrate 110, and an oxide layer 123, which is disposed on the substrate 110 and the conductive wire patterns 121, and the oxide layer 123 may be relatively thinner in an area where it contacts the substrate 110 than in an area where it contacts the conductive wire patterns 121.

That is, the thickness of the conductive wire patterns 121 may be smaller than the depth of the recessed patterns of the substrate 110. Otherwise, the conductive wire patterns 121 may be connected to one another over the substrate 110, thereby deteriorating the optical properties of the wire grid polarizer of FIG. 3.

The rest of the wire grid polarizer of FIG. 3 is almost the same as that of the wire grid polarizer of FIG. 1, and thus, a detailed description thereof will be omitted.

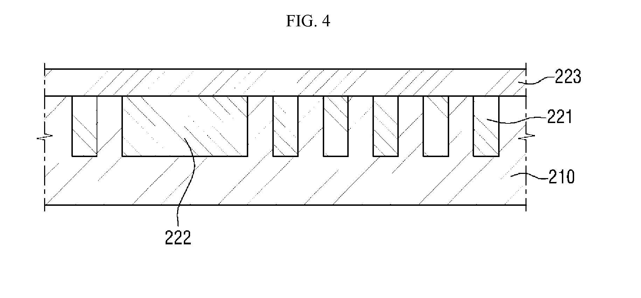

FIG. 4 is a vertical cross-sectional view of a wire grid polarizer according to another exemplary embodiment.

Referring to FIG. 4, the wire grid polarizer according to another exemplary embodiment includes a substrate 210, which has a plurality of first recessed patterns formed thereon with a relatively small width and a second recessed pattern also formed thereon with a relatively large width, a plurality of conductive wire patterns 221, which are disposed in the first recessed patterns, respectively, of the substrate 210, a reflective layer 222, which is disposed in the second recessed pattern of the substrate 210, and an oxide layer 223, which is disposed on the substrate 210, the conductive wire patterns 221, and the reflective layer 222.

The reflective layer 222 may be formed in an area corresponding to a non-opening part of a display device having the wire grid polarizer of FIG. 4. For example, the reflective layer 222 may be formed in a wiring area or a transistor area, but the embodiments are not limited thereto.

The reflective layer 222 may reflect light incident upon the non-opening part of the display device from a backlight unit (not illustrated), and may thus allow the light to be used in an opening part of the display device. Accordingly, the reflective layer 222 may improve the luminance of the display device.

The rest of the wire grid polarizer of FIG. 4 is almost the same as that of the wire grid polarizer of FIG. 1, and thus, a detailed description thereof will be omitted.

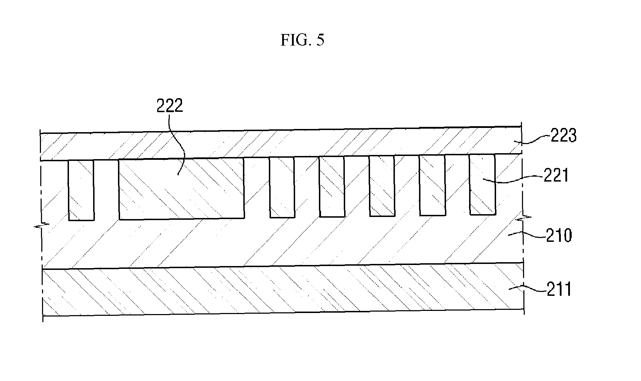

FIG. 5 is a vertical cross-sectional view of a wire grid polarizer according to another exemplary embodiment.

Referring to FIG. 5, the wire grid polarizer according to another exemplary embodiment includes a supporting substrate 211, a substrate 210, which is formed on the supporting substrate 211 and has a plurality of first recessed patterns formed thereon with a relatively small width and a second recessed pattern also formed thereon with a relatively large width, a plurality of conductive wire patterns 221, which are disposed in the first recessed patterns, respectively, of the substrate 210, a reflective layer 222, which is disposed in the second recessed pattern of the substrate 210, and an oxide layer 223, which is disposed on the substrate 210, the conductive wire patterns 221, and the reflective layer 222.

The supporting substrate 211 may be formed on one surface of the substrate 210 to improve the supporting force or processability of the substrate 210.

The material of the supporting substrate 211 may be appropriately selected in consideration of the purpose of use of the substrate 210 and the type of processing that the substrate 210 is to be subjected, as long as it allows the supporting substrate 211 to transmit visible light therethrough. In an exemplary embodiment, the supporting substrate 211 may be formed of various polymers such as glass, quartz, acrylic, TAC, a COP, a COC, PC, PET, or PES, but the embodiments are not limited thereto.

The rest of the wire grid polarizer of FIG. 5 is almost the same as that of the wire grid polarizer of FIG. 1, and thus, a detailed description thereof will be omitted.

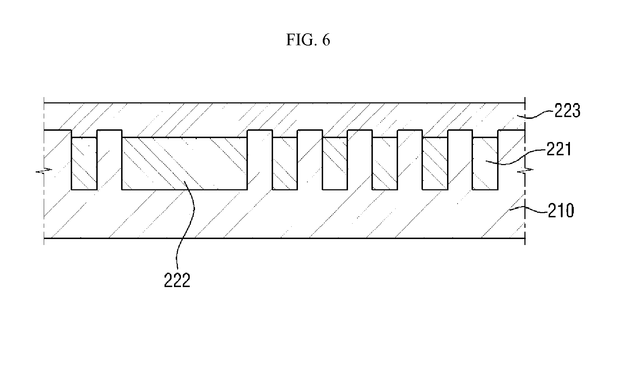

FIG. 6 is a vertical cross-sectional view of a wire grid polarizer according to another exemplary embodiment.

Referring to FIG. 6, the wire grid polarizer according to another exemplary embodiment includes a substrate 210, which has a plurality of first recessed patterns formed thereon with a relatively small width and a second recessed pattern also formed thereon with a relatively large width, a plurality of conductive wire patterns 221, which are disposed in the first recessed patterns, respectively, of the substrate 210, a reflective layer 222, which is disposed in the second recessed pattern of the substrate 210, and an oxide layer 223, which is disposed on the substrate 210, the conductive wire patterns 221, and the reflective layer 222. The oxide layer 223 may be relatively thinner in an area where it contacts the substrate 210 than in an area where it contacts the conductive wire patterns 221 and the reflective layer 222.

That is, the thickness of the conductive wire patterns 221 and the reflective layer 222 may be smaller than the depth of the recessed patterns of the substrate 210. Otherwise, the conductive wire patterns 221 may be connected to one another over the substrate 210, thereby deteriorating the optical properties of the wire grid polarizer of FIG. 6.

The rest of the wire grid polarizer of FIG. 6 is almost the same as that of the wire grid polarizer of FIG. 1, and thus, a detailed description thereof will be omitted.

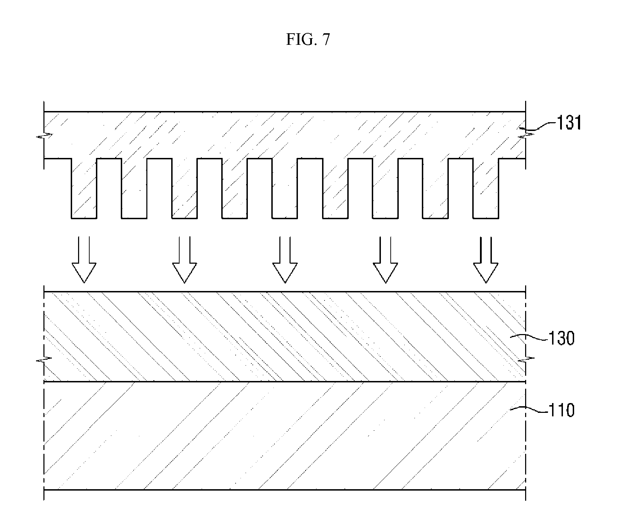

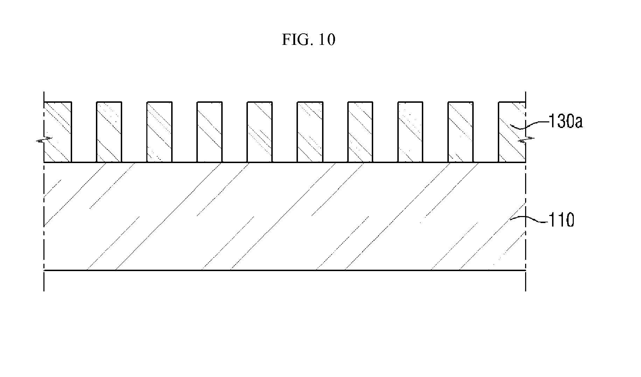

FIGS. 7 to 13 are cross-sectional views illustrating a method of fabricating a wire grid polarizer, according to an exemplary embodiment.

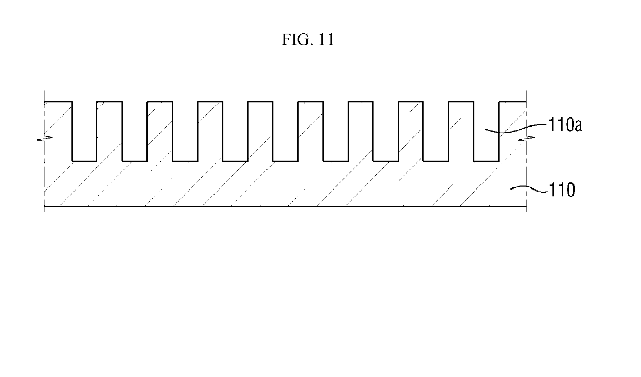

Referring to FIGS. 7 to 11, a plurality of recessed patterns 110a (FIG. 11) may be formed on one surface of the substrate 110.

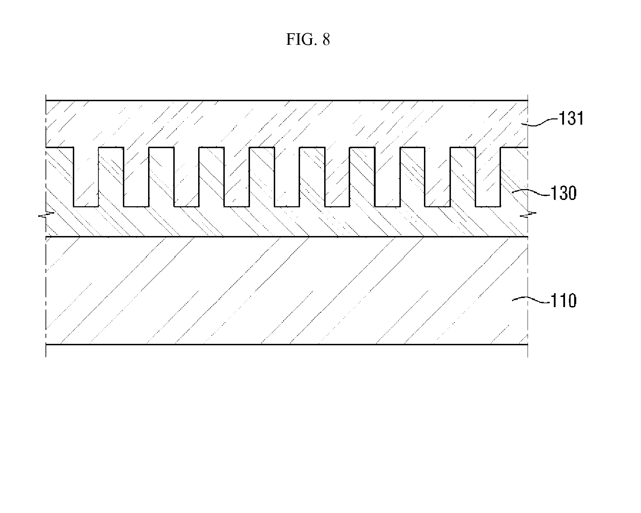

More specifically, an imprint resin layer 130 may be formed on the substrate 110 as illustrated in FIG. 7, and a patterned mold 131 may be pressed into the imprint resin layer 130 as illustrated in FIG. 8. The imprint resin layer 130 may be cured with the mold 131 pressed thereinto. Since the substrate 110 is formed of a transparent material, the imprint resin layer 130 may be cured by an optical curing method, which involves the use of, for example, ultraviolet (UV) light. Alternatively, the imprint resin layer 130 may be cured by a thermal curing method or a combination of the optical curing method and the thermal curing method.

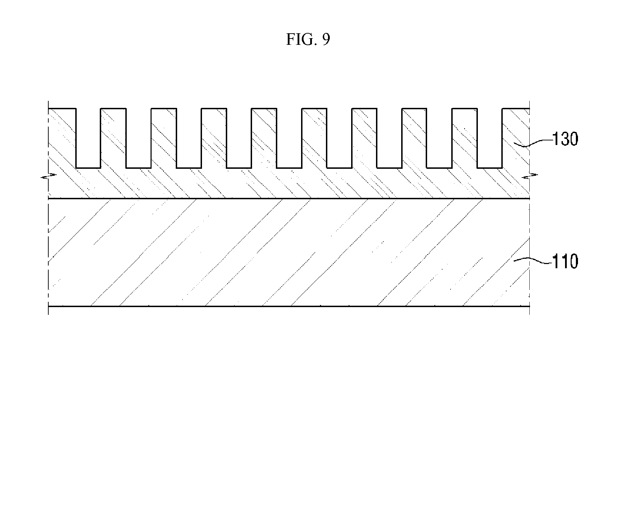

Thereafter, the mold 131 and portions of the imprint resin layer 130 at the bottom of the mold 131 may be removed, thereby forming a plurality of mask patterns 130a as illustrated in FIGS. 9-10.

Thereafter, the substrate 110 may be etched by using the mask patterns 130a as a mask. As a result, the substrate 110 with the recessed patterns 110a may be obtained as illustrated in FIG. 11.

However, the formation of the recessed patterns 110a on the substrate 110 is not limited to the aforementioned imprinting method. Rather, any patterning method that can pattern the substrate 110 to any desired nano size may be used to form the recessed patterns 110a on the substrate 110. Examples of such nano-patterning methods include photoresist patterning, double patterning technology (DPT), and block copolymer (BCP) alignment patterning, but the embodiments are not limited thereto.

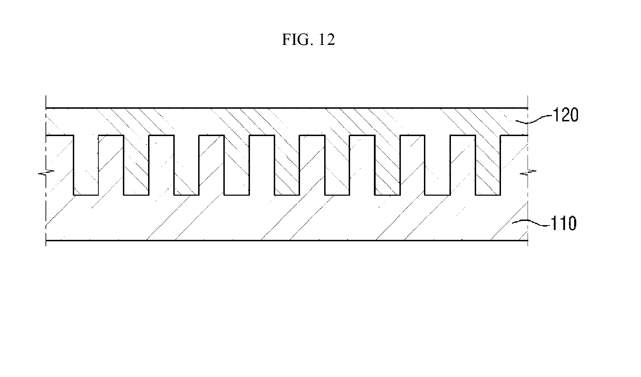

Referring to FIG. 12, a conductive material layer 120 may be formed on the entire upper surface of the substrate 110 and within the recessed patterns 110a. Any method that can completely fill the recessed patterns 110a with the conductive material layer 120 may be used to form the conductive material layer 120. For example, the conductive material layer 120 may be formed by chemical vapor deposition (CVD) or atomic layer deposition (ALD), but the embodiments are not limited thereto. Even a method that produces irregularities under particular conditions may be used after an adjustment of the conditions for deposition thereof, if the method can completely fill the recessed patterns 110a with the conductive material layer 120.

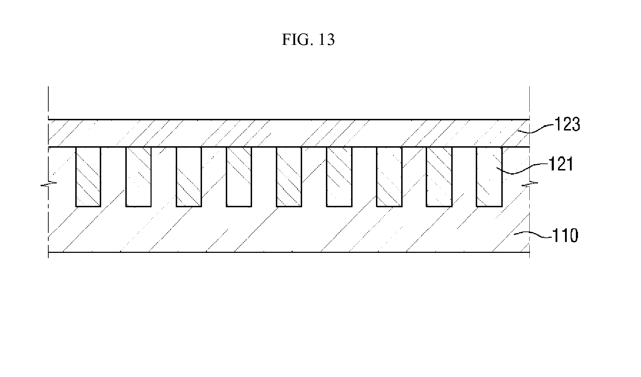

Referring to FIG. 13, the conductive material layer 120 may be oxidized, thereby forming an oxide layer 123 and a plurality of conductive wire patterns 121, which account for parts of the conductive material layer 120 that are not oxidized. Any oxidation method that can oxidize the conductive material layer 120, for example, anodic oxidation or plasma oxidation, may be used, but the embodiments are not limited thereto.

The thickness of the oxide layer 123, i.e., the depth of oxidation, may be adjusted by controlling the duration of oxidation or the intensity of the plasma. The conductive material layer 120 may be oxidized to the extent that the depth of oxidation reaches the substrate 110. Otherwise, the conductive wire patterns 121 may be connected to one another over the substrate 110, thereby deteriorating the optical properties of a wire grid polarizer. In an exemplary embodiment, the oxide layer 123 may be formed in consideration of processing margin to be relatively thinner in an area where it contacts the substrate 110 than in an area where it contacts the conductive wire patterns 121.

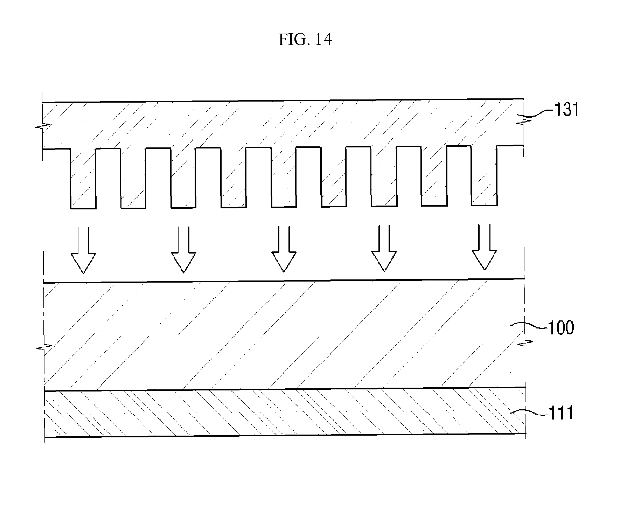

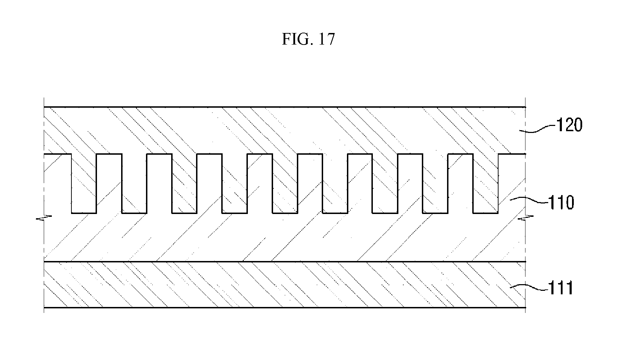

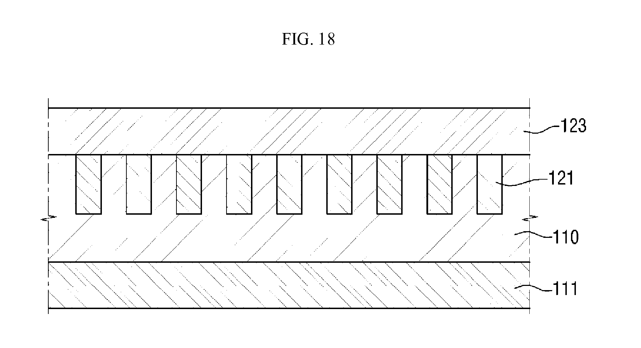

FIGS. 14 to 18 are cross-sectional views illustrating a method of fabricating a wire grid polarizer, according to another exemplary embodiment.

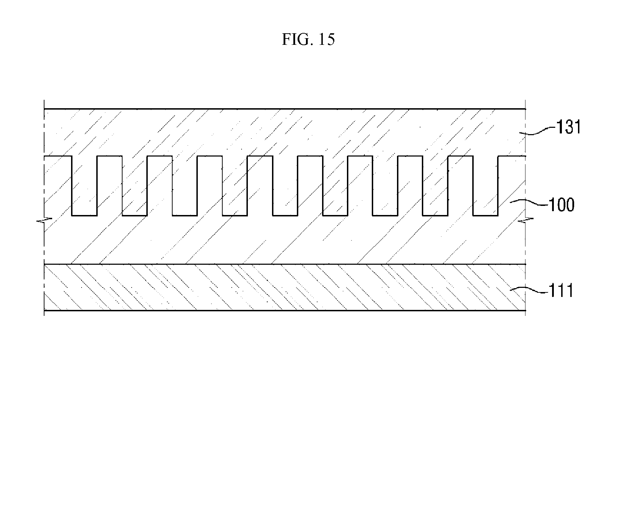

Referring to FIGS. 14 to 18, a substrate precursor layer 100 may be formed on a supporting substrate 111 as illustrated in FIG. 14, and a patterned mold 131 may be pressed into the substrate precursor layer 100 as illustrated in FIG. 15. The substrate precursor layer 100 may be cured with the mold 131 pressed thereinto. An optical curing method, a thermal curing method or an opto-thermal curing method may be used to cure the substrate precursor layer 100.

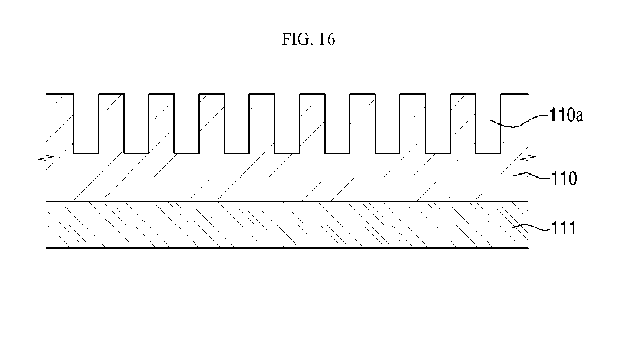

Thereafter, the mold 131 may be removed, thereby forming a substrate 110 with a plurality of recessed patterns 110a on one surface thereof and with the supporting substrate 111 on the other surface thereof as illustrated in FIG. 16.

The rest of the method of fabricating a wire grid polarizer, according to the exemplary embodiment of FIGS. 14 to 18, is almost the same as that of the method of fabricating a wire grid polarizer, according to the exemplary embodiment of FIGS. 7 and 13, and thus, a detailed description thereof will be omitted.

Even though not specifically illustrated in FIGS. 14 to 18, the supporting substrate 111 may be removed. More specifically, after the patterning of the substrate 110, the supporting substrate 111 may be peeled off from the substrate 110.

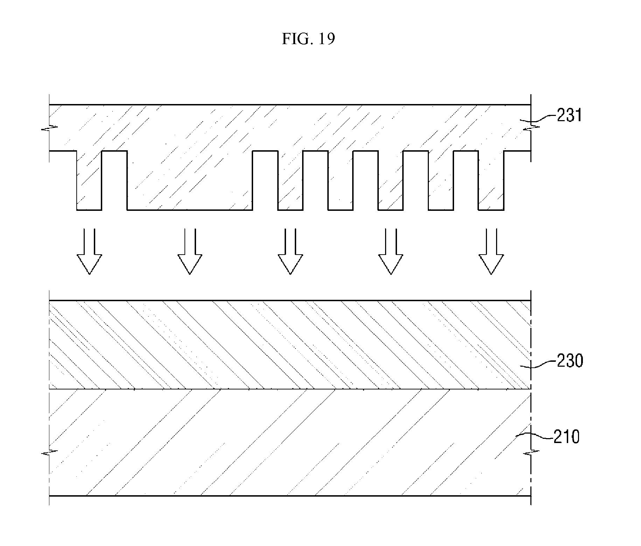

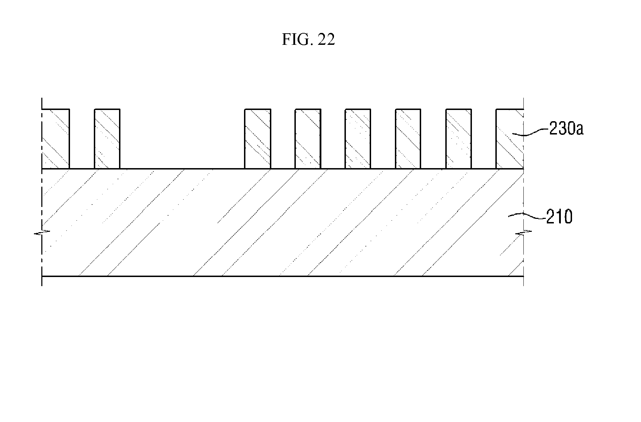

FIGS. 19 to 25 are cross-sectional views illustrating a method of fabricating a wire grid polarizer, according to another exemplary embodiment.

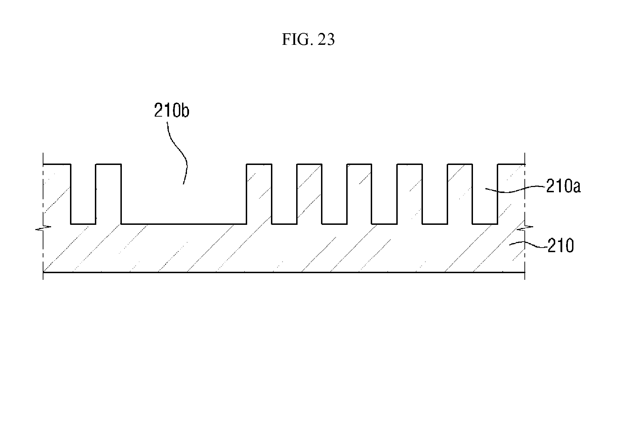

Referring to FIGS. 19 to 23, a plurality of first recessed patterns 210a and a second recessed pattern 210b may be formed on one surface of a substrate 210 as illustrated in FIG. 23.

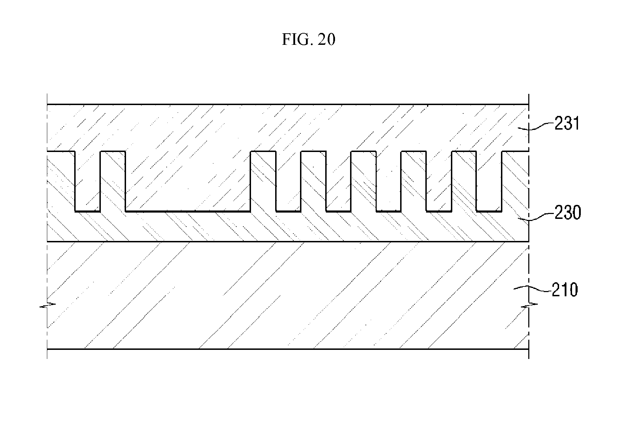

More specifically, an imprint resin layer 230 may be formed on the substrate 210 as illustrated in FIG. 19, and a patterned mold 231 may be pressed into the imprint resin layer 230 as illustrated in FIG. 20. The imprint resin layer 230 may be cured with the mold 231 pressed thereinto. Since the substrate 210 is formed of a transparent material, the imprint resin layer 230 may be cured by an optical curing method, which involves the use of, for example, UV light. Alternatively, the imprint resin layer 230 may be cured by a thermal curing method or a combination of the optical curing method and the thermal curing method.

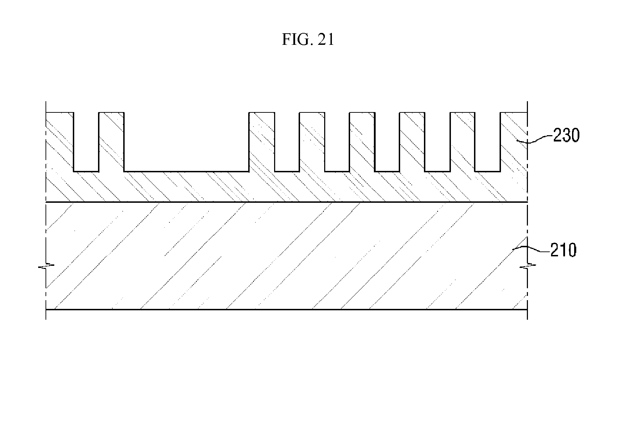

Thereafter, the mold 231 and portions of the imprint resin layer 230 at the bottom of the mold 231 may be removed, thereby forming a plurality of mask patterns 230a as illustrated in FIGS. 21-22.

Thereafter, the substrate 210 may be etched by using the mask patterns 230a as a mask. As a result, the substrate 210 with the first recessed patterns 210a and the second recessed pattern 210b may be obtained as illustrated in FIG. 23.

However, the formation of the first recessed patterns 210a and the second recessed pattern 210b on the substrate 210 is not limited to the aforementioned imprinting method. Rather, any patterning method that can pattern the substrate 210 to any desired nano size may be used to form the first recessed patterns 210a and the second recessed pattern 210b on the substrate 210. Examples of such nano-patterning methods include photoresist patterning, DPT, and BCP alignment patterning, but the embodiments are not limited thereto.

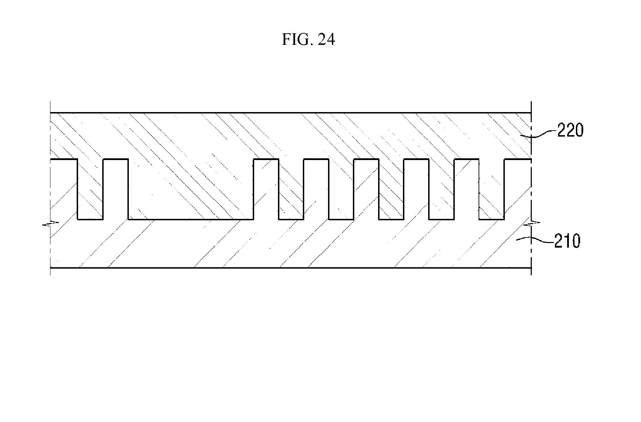

Referring to FIG. 24, a conductive material layer 220 may be formed on the entire upper surface of the substrate 210 and within the first recessed patterns 210a and the second recessed pattern 210b. Any method that can completely fill the first recessed patterns 210a and the second recessed pattern 210b with the conductive material layer 220 may be used to form the conductive material layer 220. For example, the conductive material layer 220 may be formed by CVD or ALD, but the embodiments are not limited thereto. That is, even a method that produces irregularities under particular conditions may be used after an adjustment of the conditions for deposition thereof, if the method can completely fill the first recessed patterns 210a and the second recessed pattern 210b with the conductive material layer 220.

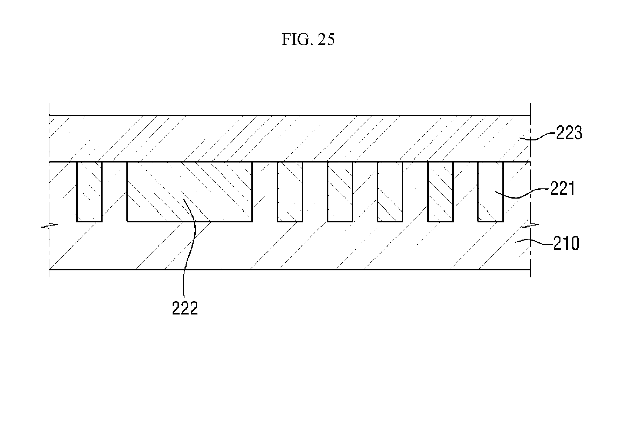

Referring to FIG. 25, the conductive material layer 220 may be oxidized, thereby forming an oxide layer 223 and a plurality of conductive wire patterns 221 and a reflective layer 222, which account for parts of the conductive material layer 220 that are not oxidized. Any oxidation method that can oxidize the conductive material layer 220, for example, anodic oxidation or plasma oxidation, may be used, but the embodiments are not limited thereto.

The thickness of the oxide layer 223, i.e., the depth of oxidation, may be adjusted by controlling the duration of oxidation or the intensity of the plasma. The conductive material layer 220 may be oxidized to the extent that the depth of oxidation reaches the substrate 210. Otherwise, the conductive wire patterns 221 and the reflective layer 222 may be connected to one another over the substrate 210, thereby deteriorating the optical properties of a wire grid polarizer. In an exemplary embodiment, the oxide layer 223 may be formed in consideration of processing margin to be relatively thinner in an area where it contacts the substrate 210 than in an area where it contacts the conductive wire patterns 221 and the reflective layer 222.

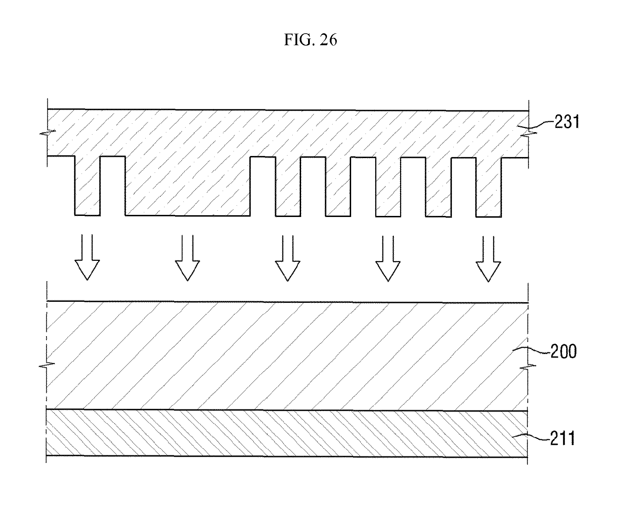

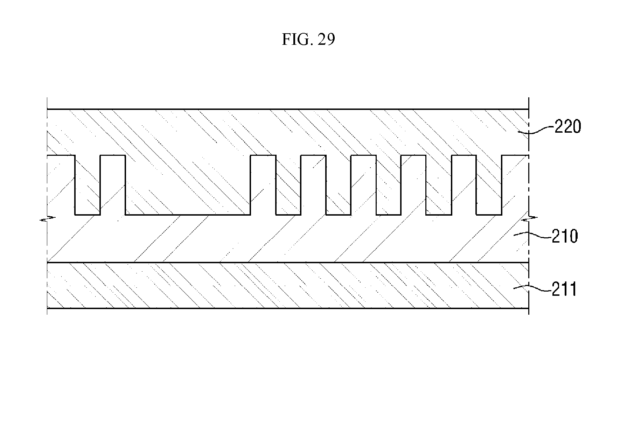

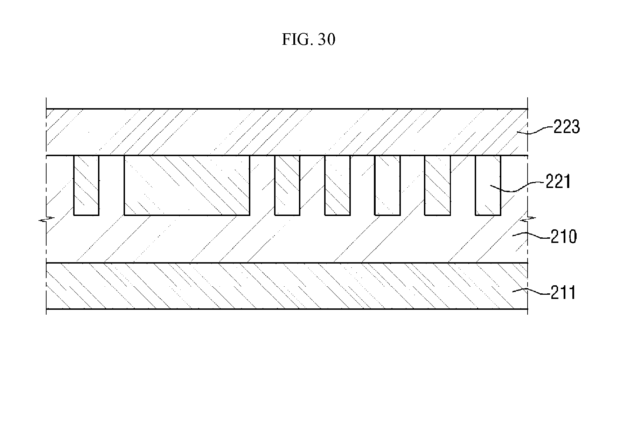

FIGS. 26 to 30 are cross-sectional views illustrating a method of fabricating a wire grid polarizer, according to another exemplary embodiment.

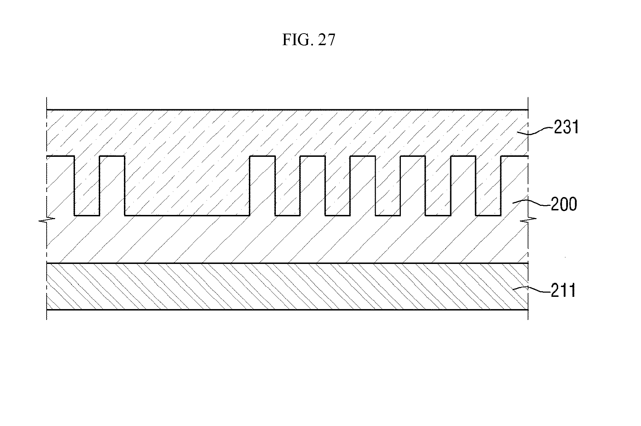

Referring to FIGS. 26 to 30, a substrate precursor layer 200 may be formed on a supporting substrate 211 as illustrated in FIG. 26, and a patterned mold 231 may be pressed into the substrate precursor layer 200 as illustrated in FIG. 27. The substrate precursor layer 200 may be cured with the mold 231 pressed thereinto. An optical curing method, a thermal curing method or an opto-thermal curing method may be used to cure the substrate precursor layer 200.

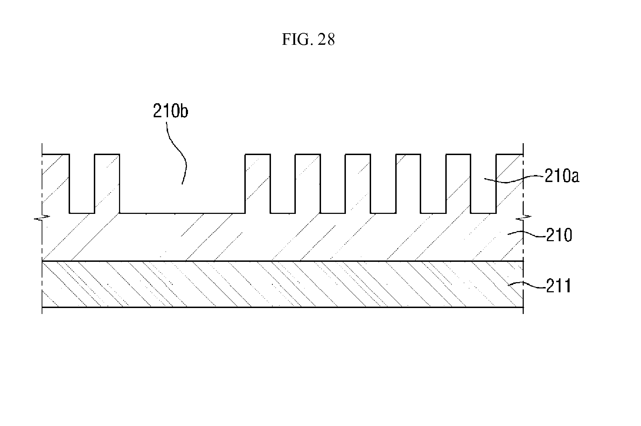

Thereafter, the mold 231 may be removed, thereby forming a substrate 210 with a plurality of first recessed patterns 210a and a second recessed pattern 210b on one surface thereof and with the supporting substrate 211 on the other surface thereof as illustrated in FIG. 28.

The rest of the method of fabricating a wire grid polarizer, according to the exemplary embodiment of FIGS. 26 to 30, is almost the same as that of the method of fabricating a wire grid polarizer, according to the exemplary embodiment of FIGS. 19 and 25, and thus, a detailed description thereof will be omitted.

Even though not specifically illustrated in FIGS. 26 to 30, the supporting substrate 211 may be removed. More specifically, after the patterning of the substrate 210, the supporting substrate 211 may be peeled off from the substrate 210.

However, the effects of the inventive concept are not restricted to the one set forth herein. The above and other effects of the inventive concept will become more apparent to one of daily skill in the art to which the inventive concept pertains by referencing the claims.

## Claims

1. A wire grid polarizer, comprising:
a substrate (110) configured to have a plurality of first recessed patterns disposed on a first surface thereof;
a plurality of conductive wire patterns (121) configured to be disposed in the first recessed patterns, respectively, of the substrate (110); and
an oxide layer configured to be disposed on the substrate (110) and the conductive wire patterns (121).

2. The wire grid polarizer of claim 1, further comprising:
a supporting substrate (111) configured to be provided on a second surface of the substrate (110).

3. The wire grid polarizer of anyone of claims 1 to 2, wherein the substrate is further configured to have a refractive index of 1.0 to 1.7.

4. The wire grid polarizer of anyone of claims 1 to 3, wherein the oxide layer is further configured to have a thickness of 100 nm to 1000 nm.

5. The wire grid polarizer of anyone of claim 1s to 4, wherein the oxide layer is further configured to contact the substrate (110) and the conductive wire patterns (121).

6. The wire grid polarizer of anyone of claims 1 to 5, wherein the oxide layer (123) is further configured to be thinner in an area where it contacts the substrate (110) than in an area where it contacts the conductive wire patterns (121).

7. A wire grid polarizer of anyone of claims 1 to 6, comprising:
a second recessed pattern also disposed on the first surface thereof with a width larger than a width of the first recessed patterns;
a reflective layer (222) configured to be disposed in the second recessed pattern of the substrate (110); and
the oxide layer (123) configured to be disposed also on the reflective layer.

8. The wire grid polarizer of anyone of claims 1 to 7, wherein the oxide layer (123) is further configured to contact the substrate (110), the conductive wire patterns (121), and the reflective layer (222).

9. The wire grid polarizer of anyone of claims 1 to 8, wherein the oxide layer (223) is further configured to be thinner in an area where it contacts the substrate (110) than in an area where it contacts the conductive wire patterns (121).

10. A method of fabricating a wire grid polarizer, the method comprising:
forming a plurality of first recessed patterns (110a) on a first surface of a substrate (110);
forming a conductive material layer on the first surface of the substrate (110) to form a plurality of conductive wire patterns (121) in the first recessed patterns (110a), respectively; and
oxidizing part of the conductive material layer on the substrate (110).

11. The method of claim 10, wherein the forming the conductive material layer, comprises using chemical vapor deposition (CVD) or atomic layer deposition (ALD).

12. The method of claims 10 or 11, wherein the forming the recessed patterns, comprises:
forming a pattern mask on the substrate; and
forming the recessed patterns (110a) by using the pattern mask.

13. The method of anyone of claims 10 tol2, wherein the forming the recessed patterns, comprises:
applying a substrate precursor layer on a supporting substrate (111);
imprinting the substrate precursor layer; and
curing the imprinted substrate precursor layer.

14. The method of anyone of claims 10 to 13, further comprising:
removing the supporting substrate (111).

15. A method of fabricating a wire grid polarizer of anyone of claims 10 to 14,
forming a plurality of a second recessed patterns with a width larger than a width of the first recessed patterns (110a) on a first surface of a substrate (110);
forming a reflective layer (222) in the second recessed patterns.
